# FASCICULE DE BREVET EUROPEEN

(11) **EP 3 671 243 B1**
(45) Date de publication et mention de la délivrance du brevet: **19.04.2023**
(21) Numéro de dépôt: 19215422.7
(22) Date de dépôt: 11.12.2019
(51) Int. Cl.: G01R 31/392, G01R 31/396

(54) **PROCÉDÉ DE DÉTERMINATION DE L'ÉTAT DE SANTÉ DES CELLULES D'UNE BATTERIE**
VERFAHREN ZUR BESTIMMUNG DES GESUNDHEITSZUSTANDS DER ZELLEN EINER BATTERIE
METHOD FOR DETERMINING THE STATE OF HEALTH OF THE CELLS OF A BATTERY

(30) Priorité: 12.12.2018 FR 1872805
(43) Date de publication de la demande: 24.06.2020
(73) Titulaire: Commissariat à l'Energie Atomique et aux Energies Alternatives, 75015 Paris (FR)
(72) Inventeur: CROUZEVIALLE, Bruno, 38054 GRENOBLE CEDEX 9 (FR); DELAILLE, Arnaud, 38054 GRENOBLE CEDEX 9 (FR)
(74) Mandataire: Cabinet Beaumont

(56) Documents cités:
- EP-A1- 3 258 282
- EP-A1- 3 276 364
- WO-A1-2015/162259
- US-A1- 2015 260 795

## Description

### Domaine technique

La présente description concerne le domaine des batteries électriques de façon générale, et vise plus particulièrement la détermination de l'état de santé ou état de vieillissement des cellules d'une batterie.

### Technique antérieure

Une batterie électrique est un groupement de plusieurs cellules rechargeables reliées en série et/ou en parallèle entre deux noeuds ou bornes de fourniture de tension.

Dans certaines applications, on souhaite pouvoir estimer, pour chaque cellule d'une batterie, un indicateur représentatif du vieillissement de la cellule, généralement appelé SOH, de l'anglais "State of Health" pour état de santé. A un instant donné de la vie d'une cellule, le SOH peut être défini comme étant le rapport de la capacité de la cellule (c'est-à-dire la charge maximale qu'est capable de stocker et délivrer la cellule) à l'instant considéré, sur une capacité de référence de la cellule, par exemple sa capacité nominale (c'est-à-dire la capacité indiquée par le constructeur), ou sa capacité mesurée à l'état neuf.

La connaissance du SOH de chaque cellule peut par exemple permettre d'identifier des cellules défectueuses pour les isoler ou les remplacer, ou de recaler ou réajuster les jauges d'état de charge des cellules pour tenir compte du vieillissement des cellules.

La demande de brevet EP3276364 (DD17299/B15316) précédemment déposée par le demandeur décrit une méthode d'estimation du SOH des différentes cellules d'une batterie à partir d'une unique phase de décharge ou de charge complète de la batterie.

Cette méthode nécessite toutefois de mémoriser l'évolution de la tension aux bornes de chacune des cellules de la batterie tout au long de la phase de décharge ou de charge de la batterie. Ceci peut s'avérer contraignant et poser des difficultés dans certaines applications, notamment lorsque le nombre de cellules de la batterie est important, dans la mesure où la quantité de données à mémoriser est alors relativement élevée.

Le document US2015/260795 décrit une méthode d'estimation du SOH d'une cellule de batterie.

### Résumé de l'invention

Un mode de réalisation prévoit un procédé de détermination de l'état de santé des cellules d'une batterie comportant une pluralité de cellules reliées en série comme défini dans la revendication indépendante 1.

Selon un mode de réalisation, le procédé comprend en outre la fourniture, pour chaque autre cellule de la batterie, d'une valeur estimée de la capacité de la cellule égale à Qtot+ΔQCi, Qtot étant la charge extraite de la batterie ou injectée dans la batterie entre le début et la fin d'une phase de décharge complète ou de charge complète de la batterie.

Selon un mode de réalisation, le procédé comporte en outre la fourniture, pour chaque autre cellule de la batterie, d'un indicateur d'état de santé de la cellule calculé en tenant compte de ladite valeur estimée de la capacité Qtot+ΔQCi de la cellule.

Selon un mode de réalisation, à l'étape a), la décharge ou la charge de la batterie est réalisée dans des conditions de courant et/ou de température sensiblement identiques à celles pour lesquelles ont été tracées des courbes de référence de la bibliothèque.

Selon un mode de réalisation, la bibliothèque contient des courbes de décharge ou de charge de référence pour plusieurs conditions distinctes de courant et/ou de température.

Selon un mode de réalisation, la bibliothèque contient des courbes de décharge ou de charge de référence pour plusieurs conditions distinctes de vieillissement, et, à l'étape d), la courbe de référence est sélectionnée en tenant compte des conditions de vieillissement de la batterie.

Selon un mode de réalisation, la bibliothèque de référence comprend une pluralité de courbes de décharge ou de charge de référence pour respectivement une pluralité de valeurs discrètes d'état de santé.

Selon un mode de réalisation, la courbe de référence sélectionnée à l'étape d) est la courbe de référence disponible dans la bibliothèque pour la plus grande valeur d'état de santé strictement inférieure à l'indicateur d'état de santé de la première cellule déterminé à l'étape c).

Selon un mode de réalisation, le procédé comprend en outre :
- préalablement à ladite phase de décharge, une étape de charge de la batterie jusqu'à un seuil de pleine charge ; ou
- préalablement à ladite phase de charge, une étape de décharge de la batterie jusqu'à un seuil de décharge.

Selon un mode de réalisation, l'étape préalable de charge ou de décharge de la batterie comporte un équilibrage des cellules de la batterie.

Un autre mode de réalisation prévoit un procédé de revalorisation de cellules de batterie usagées comportant une étape de diagnostic des cellules mettant en oeuvre un procédé tel que défini ci-dessus.

Selon un mode de réalisation, le procédé comporte en outre une étape de sélection de cellules dont l'indicateur d'état de santé satisfait une condition prédéfinie, et une étape d'assemblage des cellules sélectionnées en une nouvelle batterie.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est un logigramme illustrant, sous forme de blocs, un exemple d'un procédé de détermination de l'état de santé des cellules d'une batterie selon un mode de réalisation ;
la figure 2 est un diagramme représentant un jeu de mesure des tensions des cellules d'une batterie à la fin d'une phase de décharge de la batterie ;
la figure 3 est un diagramme représentant une bibliothèque de courbes de décharge de référence d'une cellule élémentaire de batterie pour différents états de santé de la cellule ; et
la figure 4 est un diagramme illustrant un principe de fonctionnement du procédé de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses utilisations qui peuvent être faites du SOH des cellules d'une batterie n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

On s'intéresse ici plus particulièrement à la détermination du SOH des cellules d'une batterie comportant plusieurs cellules reliées en série entre une borne positive et une borne négative de la batterie. Les cellules de la batterie sont de préférence identiques aux dispersions de fabrication et de vieillissement près. Chaque cellule peut comporter une unique cellule élémentaire de type pile, accumulateur, etc., ou plusieurs cellules élémentaires reliées en série et/ou en parallèle entre une borne positive et une borne négative de la cellule. Les cellules élémentaires sont par exemple des cellules au lithium, par exemple des cellules de type lithium-ion, lithium-métal-polymère, etc. Plus généralement, les modes de réalisation décrits s'appliquent à toutes ou à la plupart des technologies de cellules élémentaires de batterie connues.

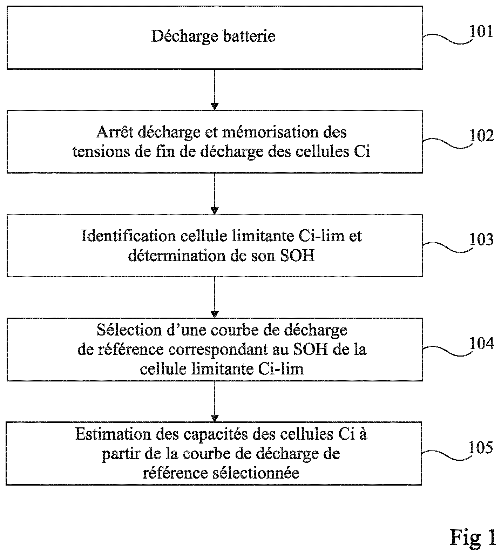

La figure 1 est un logigramme illustrant, sous forme de blocs, un exemple d'un procédé de détermination de l'état de santé des cellules d'une batterie selon un mode de réalisation.

On considère dans cet exemple une batterie comportant n cellules C1, ..., Cn reliées en série entre une borne positive et une borne négative de la batterie, avec n entier supérieur ou égal à 2, par exemple supérieur ou égal à 3.

Un outil de diagnostic (non détaillé) est connecté à la batterie, cet outil comportant n capteurs de tension connectés respectivement aux bornes des n cellules Ci de la batterie, avec i entier allant de 1 à n. Chaque capteur de tension est adapté à mesurer la tension Ui aux bornes de la cellule Ci à laquelle il est associé. L'outil de diagnostic peut en outre comporter un compteur coulométrique ou un intégrateur de courant connecté à au moins une borne de la batterie, ou tout autre élément permettant de mesurer ou d'estimer la charge extraite de la batterie lors d'une phase de décharge de la batterie. L'outil de diagnostic comporte en outre des moyens de mémorisation (mémoire, registre, etc.) d'au moins un jeu de n valeurs de tension Ui mesurées respectivement aux bornes des n cellules Ci de la batterie à un instant donné. L'outil de diagnostic peut en outre comporter une unité de traitement pouvant comporter un microprocesseur. En pratique, l'outil de diagnostic peut faire partie d'un dispositif électronique de gestion de la batterie intégré à la batterie, généralement désigné par le terme BMS, de l'anglais "Battery Management System", destiné à mettre en oeuvre des fonctions diverses telles que des fonctions d'équilibrage des cellules, des fonctions de protection, etc. En effet, les composants susmentionnés de l'outil de diagnostic sont des composants que l'on retrouve classiquement dans un dispositif de gestion de batterie de type BMS. A titre de variante, l'outil de diagnostic peut être un dispositif externe à la batterie, destiné à être connecté à la batterie lors d'une phase de diagnostic des cellules de la batterie. Dans une autre variante, l'outil de diagnostic peut être partiellement intégré à la batterie et partiellement externe à la batterie. Par exemple, les capteurs de tension de l'outil de diagnostic peuvent être internes à la batterie, et le dispositif de traitement mettant en oeuvre la méthode décrite à partir des valeurs de tension fournies par les capteurs peut être externe à la batterie. L'outil de diagnostic est configuré pour mettre en oeuvre le procédé de la figure 1 de détermination de l'état de santé des cellules de la batterie.

Le procédé de la figure 1 comprend une étape 101 au cours de laquelle la batterie est soumise à une décharge complète, par exemple à courant constant et à température ambiante constante. Préalablement à l'étape 101, si la batterie n'est pas déjà chargée, une étape de recharge résiduelle de la batterie à son niveau de pleine charge peut être mise en oeuvre. Lors de cette recharge résiduelle, un équilibrage de fin de charge est de préférence réalisé, de façon à ce que les cellules de la batterie présentent toutes sensiblement le même niveau de tension au début de la phase de décharge complète. Les techniques susceptibles d'être utilisées pour réaliser un tel équilibrage de fin de charge sont connues de l'homme du métier et ne seront pas détaillées.

Pendant la phase de décharge complète, l'outil de diagnostic surveille la tension Ui aux bornes de chaque cellule Ci de façon à interrompre la décharge lorsqu'une première cellule Ci de la batterie atteint un seuil de tension basse VL prédéfini, correspondant par exemple à un seuil critique de décharge à ne pas dépasser sous peine d'endommager la cellule. A titre d'exemple, la tension limite basse VL est définie par le fabricant des cellules. La tension VL est par exemple identique pour toutes les cellules de la batterie.

A titre d'exemple, tout au long de la phase de décharge, l'outil de diagnostic lit périodiquement les tensions Ui aux bornes des différentes cellules de la batterie, et vérifie à chaque lecture si l'une des cellules Ci n'a pas atteint son niveau de tension de fin de décharge VL. A chaque itération, les n tensions Ui sont par exemple lues en parallèle (c'est-à-dire simultanément) et mémorisées dans un registre ou une mémoire de l'outil de diagnostic, avant d'être comparées une à une au seuil VL par l'unité de traitement. Si aucune des n tensions Ui mesurées n'est inférieure ou égale au seuil VL, les n valeurs de tensions Ui mémorisées peuvent être écrasées à l'itération suivante (c'est-à-dire remplacées par les n nouvelles valeurs de tension Ui lues) . Ainsi, dans cet exemple, seul le dernier jeu de tensions Ui lu par l'outil de diagnostic est conservé en mémoire.

L'outil de diagnostic peut en outre acquérir et mémoriser, à chaque lecture, la valeur de la charge Q extraite de la batterie depuis le début de la phase de décharge. A titre d'exemple, à chaque itération, seule la dernière valeur lue de la charge extraite Q est conservée en mémoire par l'outil de diagnostic.

Lors d'une étape 102, lorsqu'une première cellule Ci de la batterie atteint son niveau de tension de fin de décharge VL, la décharge de la batterie est interrompue. Le dernier jeu de tensions Ui lu par l'outil de diagnostic est alors conservé en mémoire en vue d'une étape ultérieure d'estimation des capacités des n cellules Ci. La valeur Qtot de la charge extraite de la batterie depuis le début de la phase de décharge est également mémorisée.

Lors d'une étape 103, la cellule Ci ayant atteint en premier son seuil de décharge VL et ayant ainsi provoqué l'arrêt de la décharge de la batterie, est identifiée par l'outil de diagnostic comme étant la cellule limitante Ci_lim de la batterie.

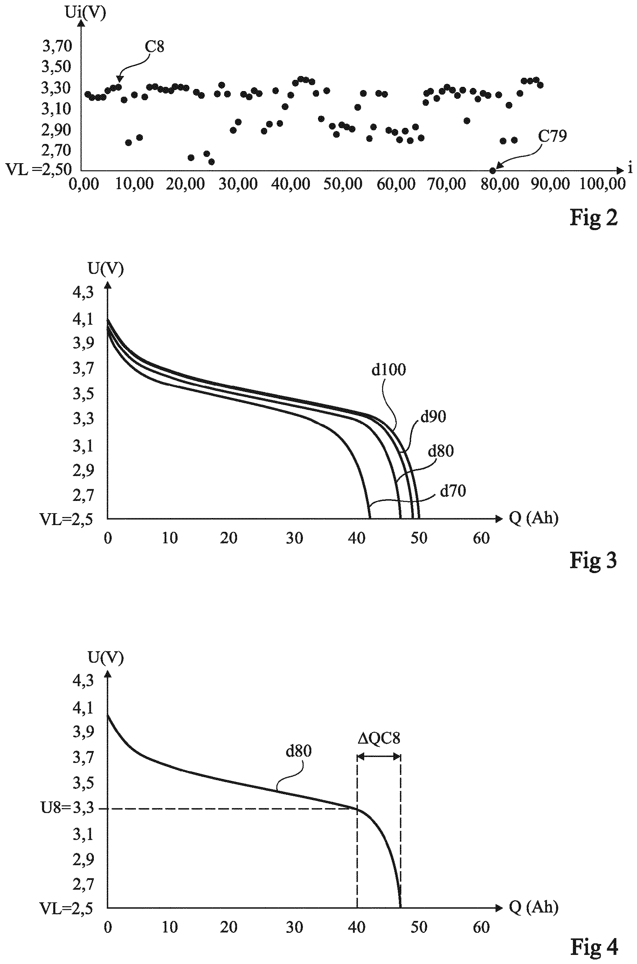

La figure 2 est un diagramme illustrant, à titre d'exemple, dans le cas d'une batterie de n=90 cellules, un jeu de tension Ui mémorisé par l'outil de diagnostic à l'issue de la phase de décharge complète de la batterie. Dans cet exemple, on a considéré une batterie constituée de cellules élémentaires présentant un niveau de pleine charge de l'ordre de 4,1 V (non visible sur la figure 2) et un seuil de fin de décharge VL de l'ordre de 2,5 V. Le diagramme de la figure 2 comprend n=90 points correspondant respectivement, pour chaque numéro i de cellule (en abscisse), avec i entier allant de 1 à n, à la tension Ui de la cellule (en ordonnée, en volts), à la fin de la phase de décharge complète de la batterie. Comme cela apparaît sur la figure 2, dans cet exemple, la cellule limitante est la cellule C79, présentant une tension U79 de fin de décharge sensiblement égale au seuil VL. Les autres cellules de la batterie ont des tensions de fin de décharge Ui supérieures à VL, comprises entre 2,5 volts et 3,4 volts dans cet exemple.

Lors de l'étape 103, l'outil de diagnostic détermine le SOH de la cellule limitante Ci_lim à partir de la valeur Qtot de la charge totale extraite de la batterie pendant la phase de décharge. La charge Qtot correspond en effet à la capacité réelle de la cellule limitante Ci_lim, qui définit la capacité de la batterie. Connaissant cette capacité Qtot, le SOH de la cellule limitante Ci_lim peut être calculé, par exemple comme étant le rapport de la capacité Qtot sur une capacité de référence de la cellule.

Dans le mode de réalisation de la figure 1, l'outil de diagnostic comprend une mémoire stockant une bibliothèque de courbes de décharge de référence d'une cellule élémentaire du type utilisé pour réaliser la batterie, pour différents états de santé de la cellule.

La figure 3 est un diagramme représentant un exemple d'une telle bibliothèque de courbes de décharge de référence. Plus particulièrement, dans l'exemple de la figure 3, la bibliothèque comprend quatre courbes de décharge de référence d100, d90, d80 et d70 correspondant respectivement à des valeurs de SOH de la cellule de 100 %, 90 %, 80 % et 70 %. Chacune des courbes de décharge d100, d90, d80 et d70 représente l'évolution, lors d'une phase de décharge complète de la cellule à un courant de décharge et une température donnés, de la tension U (en volts, en ordonnée) aux bornes de la cellule, en fonction de la charge Q (en ampère-heure, en abscisse) extraite de la cellule. Les courbes de décharge d100, d90, d80 et d70 sont de préférence tracées pour un même courant de décharge de référence iref de la cellule. En effet, la tension aux bornes d'une cellule de batterie dépend en général du courant parcourant cette cellule lors de la mesure. Les courbes de décharge d100, d90, d80 et d70 sont en outre de préférence tracées pour une même température de référence Tref de la cellule. En effet, la tension aux bornes d'une cellule de batterie dépend en général de la température de cette cellule lors de la mesure.

Au début de la phase de décharge (Q=0), la cellule est pleinement chargée. La tension U est à un niveau correspondant à la tension de pleine charge de la cellule, de l'ordre de 4,1 V dans cet exemple. Au fur et à mesure de la décharge, la tension U de la cellule décroit de façon monotone en fonction de la charge Q extraite de la batterie. La décharge s'interrompt lorsque la cellule atteint le seuil de fin de décharge VL. A l'instant où la cellule atteint son seuil de fin de décharge VL, la charge Qtot extraite de la cellule depuis le début de la phase de décharge correspond à la capacité réelle de la cellule. Le SOH de la cellule est par exemple défini comme étant le rapport de cette capacité Qtot sur une capacité de référence de la cellule, correspondant par exemple à la capacité réelle de la cellule à l'état neuf.

La bibliothèque de courbes de référence peut être mémorisée par l'outil de diagnostic sous la forme d'un ensemble de tables de mémorisation, chaque table correspondant à une courbe de décharge et stockant un ensemble discret de valeurs U(Q) de la courbe de décharge, par exemple pour un même courant de décharge et une même température.

Les courbes de décharge peuvent être fournies par le fabricant des cellules, ou être mesurées expérimentalement en laboratoire sur une cellule unitaire de référence que l'on pourra faire cycler un grand nombre de fois de façon à balayer les différentes valeurs de SOH visées. Dans l'exemple représenté, la bibliothèque de courbes de décharge de référence comprend quatre courbes de décharge de référence pour respectivement quatre valeurs de SOH allant de 100 % à 70 % inclus, par pas de 10 %. Les modes de réalisation décrits ne se limitent bien entendu pas à ce cas particulier. De préférence, la gamme de valeurs de SOH balayées s'étend depuis l'état neuf, à savoir 100 %, jusqu'à une valeur basse inférieure ou égale à 70 % et de préférence inférieure ou égale à 60 %, par pas de 10 % ou moins, et de préférence par pas de 5 % ou moins.

Lors d'une étape 104, l'outil de diagnostic sélectionne, dans sa bibliothèque de courbes de décharge de référence, une courbe de décharge de référence représentative de l'évolution de la tension d'une cellule en fonction de la charge extraite de la cellule, pour la valeur de SOH de la cellule limitante Ci_lim déterminée à l'étape 103. Dans le cas où la valeur exacte de SOH déterminée à l'étape 103 n'est pas disponible dans la bibliothèque, l'outil de diagnostic sélectionne par exemple la courbe de référence disponible pour la valeur de SOH la plus proche de la valeur déterminée à l'étape 103. A titre de variante, l'outil de diagnostic sélectionne la courbe de référence disponible pour la plus grande valeur de SOH strictement inférieure à la valeur déterminée à l'étape 103, ce qui permettra par la suite de ne pas surestimer les SOH des différentes cellules Ci de la batterie.

Lors d'une étape 105, pour chacune des cellules Ci de la batterie à l'exception de la cellule limitante Ci_lim, l'outil de diagnostic estime la capacité réelle de la cellule Ci à partir de la courbe de décharge de référence sélectionnée à l'étape 104 et de la tension de fin de décharge Ui de la cellule mémorisée à l'étape 102.

Plus particulièrement, on prévoit ici, pour chaque cellule non limitante de la batterie, d'estimer la capacité réelle de la cellule non limitante par projection de la tension de fin décharge Ui de cette cellule sur la courbe de décharge de référence sélectionnée à l'étape 104.

Cette méthode est basée sur l'hypothèse que les courbes de décharge des différentes cellules ont une forme similaire en fin de décharge. Les inventeurs ont constaté que cette hypothèse est vérifiée pour des cellules au lithium, et, plus généralement, pour toutes ou pour la plupart des autres technologies de cellules de batterie.

La figure 4 est un diagramme illustrant la méthode de projection mise en oeuvre par l'unité de traitement de l'outil de diagnostic à l'étape 105 du procédé de la figure 1.

On considère dans cet exemple que la courbe décharge de référence sélectionnée à l'étape 104 est la courbe d80 de la figure 3 (SOH = 80 %). La courbe d80 de la figure 3 a été retracée, seule, sur la figure 4. On considère à titre d'exemple illustratif la cellule C8 de l'exemple de la figure 2, pour laquelle la valeur de tension U8 enregistrée à la fin de la phase de décharge complète de la batterie est égale à 3,3 volts.

En projetant cette tension U8 sur la courbe de décharge d80, on peut estimer la variation de charge ΔQC8 subie par la batterie entre le passage de la cellule limitante Ci_lim à la tension U8 et la fin de la phase de décharge. Pour cela, l'unité de traitement de l'outil de diagnostic détermine, à partir de la courbe de décharge d80, la valeur de la charge extraite de la batterie depuis le début de la phase de décharge à l'instant de passage de la courbe d80 par la valeur de tension U8. Cette valeur de charge est soustraite à la valeur Qtot pour déterminer la variation de charge ΔQC8 subie par la batterie entre l'instant de passage de la cellule limitante Ci_lim à la tension U8 et la fin de la phase de décharge de la batterie. Cette valeur ΔQC8 est ensuite ajoutée à la valeur Qtot pour obtenir une estimation de la capacité réelle de la cellule C8. Le SOH de la cellule C8 peut alors être calculé à partir de cette estimation.

Cette opération peut être répétée par l'unité de traitement de l'outil de diagnostic pour chacune des autres cellules Ci de la batterie de façon à calculer une valeur SOH pour chacune des cellules Ci de la batterie.

Un avantage du procédé décrit en relation avec la figure 1 est qu'il permet d'estimer l'état de santé des différentes cellules d'une batterie à partir d'une unique phase de décharge complète de la batterie, et ce sans avoir à acquérir et enregistrer les courbes de décharge des différentes cellules de la batterie pendant la phase de décharge.

Cette méthode peut par exemple être mise en oeuvre par un dispositif de gestion intégré à la batterie, pendant le cycle de vie normal de la batterie, pour surveiller l'état de santé des différentes cellules de la batterie, par exemple en vue de planifier d'éventuelles opérations de maintenance de la batterie, pour optimiser l'utilisation de la batterie, ou pour prévenir un éventuel disfonctionnement.

Une autre application de la méthode proposée concerne le diagnostic des cellules d'une batterie usagée en vue de leur revalorisation. A titre d'exemple, une fois les indicateurs d'état de santé des différentes cellules déterminés par la méthode proposée, on peut prévoir de prélever les cellules dont le SOH est supérieur à un seuil, par exemple en vue de les réassembler dans une nouvelle batterie. Les autres cellules sont par exemple recyclées par récupération des métaux les constituants. On notera que si les batteries usagées à revaloriser ne présentent pas une architecture série, ces dernières peuvent être démontées et leurs cellules réassemblées en série pour mettre en oeuvre la méthode de diagnostic décrite ci-dessus.

Une autre application de la méthode proposée concerne le diagnostic de cellules neuves préalablement à leur assemblage dans une batterie. A titre d'exemple, les cellules peuvent être montées en série lors d'une phase de diagnostic préalable à l'assemblage de la batterie. Les cellules peuvent ensuite être assemblées selon une topologie série et/ou parallèle en tenant compte des dispersions de SOH identifiées lors de la phase de diagnostic pour choisir les emplacements des différentes cellules dans la batterie.

On notera que dans le procédé décrit ci-dessus, la phase de décharge complète de la batterie est de préférence réalisée dans les mêmes conditions de courant et de température que celles utilisées pour déterminer les courbes de décharge de référence de la bibliothèque.

Pour permettre la mise en oeuvre du procédé dans différentes conditions de courant et/ou de température, l'outil de diagnostic pourra mémoriser plusieurs bibliothèques de courbes de décharges de référence correspondant respectivement à des conditions différentes de courant de décharge et/ou de température.

Par ailleurs, les conditions de vieillissement utilisées pour déterminer les courbes de décharge de référence de la bibliothèque à différentes valeurs de SOH sont de préférences représentatives des conditions d'usage de la batterie à diagnostiquer. Pour permettre la mise en oeuvre du procédé pour différentes conditions de vieillissement de la batterie, l'outil de diagnostic peut mémoriser plusieurs bibliothèques de courbes de décharges de référence correspondant respectivement à des conditions différentes de vieillissement. Ainsi, l'outil de diagnostic peut sélectionner la bibliothèque la plus adaptée en fonction des conditions d'utilisation de la batterie.

Des modes de réalisation particuliers ont été décrits. Diverses variantes et modifications apparaîtront à l'homme de l'art. En particulier, bien que l'on ait décrit ci-dessus une méthode de diagnostic réalisée à partir d'une phase de décharge complète de la batterie, précédée le cas échant d'une charge résiduelle de la batterie jusqu'à son niveau de pleine charge, une méthode similaire peut être mise en oeuvre à partir d'une décharge résiduelle de la batterie depuis un niveau de charge quelconque jusqu'à son niveau de décharge, suivie d'une phase de recharge complète de la batterie. Comme dans l'exemple décrit en relation avec la figure 1, la décharge résiduelle (étape 101) est alors interrompue lorsqu'une première cellule atteint son seuil de décharge VL, et les tensions Ui de fin de décharge des n cellules Ci sont mémorisées (étape 102). A ce stade, le SOH de la cellule limitante (étape 103) ne peut toutefois pas encore être calculé. Il faut en effet attendre la fin de la phase subséquente de recharge complète de la batterie pour connaître la capacité totale Qtot de la batterie et en déduire le SOH de la cellule limitante. Une fois la recharge complète terminée et le SOH de la cellule limitante estimé, les étapes 104 et 105 sont mises en oeuvre de façon identique ou similaire à ce qui a été décrit ci-dessus, en se basant, à l'étape 105, sur les tensions Ui de fin de décharge mémorisées à l'issue de l'étape de décharge résiduelle de la batterie.

Dans une autre variante, plutôt que calculer le SOH des cellules Ci à partir des tensions Ui mesurées à la fin d'une phase de décharge (complète ou résiduelle) de la batterie, on peut prévoir d'adapter le procédé décrit ci-dessus pour calculer le SOH des cellules Ci à partir des tensions Ui mesurées à la fin d'une phase de recharge de la batterie.

A titre d'exemple, un procédé similaire à ce qui a été décrit en relation avec la figure 1 peut être mis en oeuvre à partir d'une phase de charge complète de la batterie. Pour cela, la batterie peut être au préalable déchargée jusqu'à son seuil de décharge. Un équilibrage de fin de décharge peut en outre être réalisé de façon que, au début de la phase de charge complète de la batterie, les différentes cellules Ci de la batterie aient sensiblement le même niveau de tension. Pendant la phase de recharge complète de la batterie, l'outil de diagnostic lit périodiquement la tension Ui aux bornes de chaque cellule de la batterie, et mesure la charge injectée dans la batterie depuis le début de la phase de recharge. Lorsqu'une première cellule ou cellule limitante Ci_lim atteint son niveau de pleine charge, correspondant par exemple à la tension maximale que peut supporter la cellule sans dégradation, la recharge de la batterie est interrompue, et les valeurs des tensions Ui des n cellules de la batterie sont mémorisées. La charge Qtot injectée dans la batterie depuis le début de la phase de recharge correspond à la capacité réelle de la cellule Ci_lim, qui définit la capacité de la batterie. A partir de cette valeur Qtot, l'outil de diagnostic estime le SOH de la cellule limitante Ci_lim et sélectionne, dans une bibliothèque de courbes de recharge de référence, une courbe de recharge de référence représentative de l'évolution de la tension d'une cellule en fonction de la charge injectée dans la cellule, pour la valeur de SOH de la cellule limitante Ci_lim. Pour chacune des autres cellules Ci de la batterie, la capacité réelle de la cellule Ci peut être estimée à partir de la courbe de recharge de référence sélectionnée et de la tension Ui de la cellule à la fin de la phase de recharge, selon une méthode similaire à ce qui a été décrit ci-dessus. Pour cela, pour chaque cellule Ci autre que la cellule limitante Ci_lim, la tension Ui de fin de charge de la cellule Ui est projetée sur la courbe de recharge de référence sélectionnée, de façon à estimer la variation de charge ΔQCi subie par la batterie entre l'instant de passage de la cellule limitante Ci_lim à la tension Ui et la fin de la phase de recharge de la batterie. Cette valeur ΔQCi peut ensuite être ajoutée à la valeur Qtot pour obtenir une estimation de la capacité réelle de la cellule Ci.

Une méthode similaire peut être mise en oeuvre à partir d'une recharge résiduelle de la batterie depuis un niveau de décharge quelconque, suivie d'une phase de décharge complète de la batterie. Dans ce cas, la recharge résiduelle est interrompue lorsqu'une première cellule atteint son niveau de pleine charge, et les tensions Ui de fin de recharge des n cellules Ci sont mémorisées. A ce stade, le SOH de la cellule limitante ne peut toutefois pas encore être calculé. Il faut alors attendre la fin de la phase subséquente de décharge complète de la batterie pour connaître la capacité totale Qtot de la batterie et en déduire le SOH de la cellule limitante. Les étapes de sélection d'une courbe de recharge de référence et d'estimation du SOH des cellules Ci à partir de la courbe de recharge de référence et des tension Ui de fin de recharge des cellules sont ensuite similaires à ce qui a été décrit ci-dessus.

Par ailleurs, les modes de réalisation décrits ne se limitent pas aux exemples susmentionnés dans lesquels la fin de la phase de décharge complète ou de recharge complète de la batterie est conditionnée à un passage de la tension de la cellule limitante par un seuil bas (VL) ou haut (non référencé sur les figures) . Plus généralement, dans la méthode proposée, la décharge complète ou la charge complète de la batterie peut être interrompue dès lors qu'une condition de fin de décharge ou de fin de charge prédéfinie est satisfaite par une première cellule de la batterie.

## Revendications

1. Procédé de détermination de l'état de santé des cellules (Ci) d'une batterie comportant une pluralité de cellules (Ci) reliées en série, ce procédé comportant les étapes suivantes :
a) pendant une phase de décharge (101) ou de charge de la batterie, mesurer la tension (Ui) aux bornes de chaque cellule (Ci) ;
b) lorsque une première cellule (Ci_lim) atteint une condition prédéfinie de fin de décharge ou de fin de charge, interrompre (102) la décharge ou la charge de la batterie, et mémoriser, pour chaque autre cellule (Ci), la tension (Ui) de la cellule à la fin de la phase de décharge ou de charge de la batterie ;
c) déterminer la charge Qtot extraite de la batterie ou injectée dans la batterie entre le début et la fin d'une phase de décharge complète ou de charge complète de la batterie et en déduire (103) un indicateur d'état de santé de la première cellule (Ci_lim) ;
d) sélectionner (104), dans une bibliothèque de courbes de décharge ou de charge de référence, en fonction de l'indicateur d'état de santé de la première cellule (Ci_lim) calculé à l'étape c), une courbe de référence représentative de l'évolution de la tension (U) de la première cellule en fonction de la charge extraite de la première cellule ou injectée dans la première cellule ; et
e) déterminer (105), pour chaque autre cellule (Ci) de la batterie, à partir de la courbe de référence sélectionnée à l'étape d), une estimation de la variation de charge ΔQCi subie par la cellule entre :
- le passage de la première cellule (Ci_lim) à une tension (Ui) égale à la tension de l'autre cellule (Ci) à la fin de la phase de décharge ou de charge de la batterie, et
- la fin de la phase de décharge ou de charge de la batterie.

2. Procédé selon la revendication 1, comportant en outre la fourniture, pour chaque autre cellule (Ci) de la batterie, d'une valeur estimée de la capacité de la cellule égale à Qtot+ΔQCi.

3. Procédé selon la revendication 2, comportant en outre la fourniture, pour chaque autre cellule (Ci) de la batterie, d'un indicateur d'état de santé de la cellule calculé en tenant compte de ladite valeur estimée de la capacité Qtot+ΔQCi de la cellule.

4. Procédé selon l'une quelconque des revendications 1 à 3, dans lequel, à l'étape a), la décharge ou la charge de la batterie est réalisée dans des conditions de courant et/ou de température sensiblement identiques à celles pour lesquelles ont été tracées des courbes de référence (d70, d80, d90, d100) de la bibliothèque.

5. Procédé selon l'une quelconque des revendications 1 à 4, dans lequel la bibliothèque contient des courbes de décharge (d70, d80, d90, d100) ou de charge de référence pour plusieurs conditions distinctes de courant et/ou de température.

6. Procédé selon l'une quelconque des revendications 1 à 5, dans lequel la bibliothèque contient des courbes de décharge (d70, d80, d90, d100) ou de charge de référence pour plusieurs conditions distinctes de vieillissement, et dans lequel, à l'étape d), la courbe de référence est sélectionnée en tenant compte des conditions de vieillissement de la batterie.

7. Procédé selon l'une quelconque des revendications 1 à 6, dans lequel la bibliothèque de référence comprend une pluralité de courbes de décharge (d70, d80, d90, d100) ou de charge de référence pour respectivement une pluralité de valeurs discrètes d'état de santé.

8. Procédé selon la revendication 7, dans lequel la courbe de référence sélectionnée à l'étape d) est la courbe de référence disponible dans la bibliothèque pour la plus grande valeur d'état de santé strictement inférieure à l'indicateur d'état de santé de la première cellule (Ci_lim) déterminé à l'étape c).

9. Procédé selon l'une quelconque des revendications 1 à 8, comprenant en outre :
- préalablement à ladite phase de décharge (101), une étape de charge de la batterie jusqu'à un seuil de pleine charge ; ou
- préalablement à ladite phase de charge, une étape de décharge de la batterie jusqu'à un seuil de décharge.

10. Procédé selon la revendication 9, dans lequel l'étape préalable de charge ou de décharge de la batterie comporte un équilibrage des cellules (Ci) de la batterie.

11. Procédé de revalorisation de cellules de batterie usagées comportant une étape de diagnostic des cellules mettant en oeuvre un procédé selon l'une quelconque des revendications 1 à 10.

12. Procédé selon la revendication 11 dans sa dépendance à la revendication 3, comportant en outre une étape de sélection de cellules (Ci) dont l'indicateur d'état de santé satisfait une condition prédéfinie, et une étape d'assemblage des cellules sélectionnées en une nouvelle batterie.

## Patentansprüche

1. Verfahren zum Bestimmen des Gesundheitszustandes der Zellen (Ci) einer Batterie, die eine Vielzahl von in Reihe geschalteten Zellen (Ci) aufweist, wobei dieses Verfahren die folgenden Schritte aufweist:
a) während einer Entlade- (101) oder Ladephase der Batterie, Messen der Spannung (Ui) über den Anschlüssen jeder Zelle (Ci);
b) wenn eine erste Zelle (Ci_lim) eine vordefinierte Bedingung für das Ende des Entladens oder des Ladens erreicht, Anhalten (102) des Entladens oder Ladens der Batterie und Speichern für jede andere Zelle (Ci) der Spannung (Ui) der Zelle am Ende der Entlade- oder Ladephase der Batterie;
c) Bestimmen der aus der Batterie entnommenen oder in die Batterie eingespeisten Ladung Qtot zwischen dem Beginn und dem Ende einer vollständigen Entlade- oder Ladephase der Batterie und Ableiten (103) eines Gesundheitszustands der ersten Zelle (Ci_lim);
d) Auswählen (104) aus einer Bibliothek von Referenz-Entlade- oder -Ladekurven als Funktion des Zustands des in Schritt c) berechneten Gesundheitsindikators der ersten Zelle (Ci_lim), einer Referenzkurve, die die Entwicklung der Spannung (U) der ersten Zelle als Funktion der aus der ersten Zelle entnommenen oder in die erste Zelle injizierten Ladung darstellt; und
e) Bestimmen (105), für jede andere Zelle (Ci) der Batterie, von der in Schritt d) ausgewählten Referenzkurve, eine Schätzung der Ladungsänderung ΔQCi, der Zelle zwischen:
- dem Durchlauf der ersten Zelle (Ci_lim) durch eine Spannung (Ui), die gleich der Spannung der anderen Zelle (Ci) am Ende der Entlade- oder Ladephase der Batterie ist, und
- dem Ende der Entlade- oder Ladephase der Batterie.

2. Verfahren nach Anspruch 1, ferner aufweisend das Liefern, für jede andere Zelle (Ci) der Batterie, eines geschätzten Werts für die Kapazität der Zelle gleich Qtot + ΔQCi.

3. Verfahren nach Anspruch 2, ferner aufweisend das Liefern, für jede andere Zelle (Ci) der Batterie, eines Indikators für den Gesundheitszustand der Zelle, der unter Berücksichtigung des geschätzten Werts der Kapazität Qtot + ΔQCi der Zelle berechnet wird.

4. Verfahren nach einem der Ansprüche 1 bis 3, wobei in Schritt a) das Entladen oder Laden der Batterie unter Strom- und/oder Temperaturbedingungen durchgeführt wird, die im Wesentlichen identisch mit denen sind, unter denen die Referenzkurven (d70, d80, d90, d100) aus der Bibliothek aufgezeichnet wurden.

5. Verfahren nach einem der Ansprüche 1 bis 4, wobei die Bibliothek Referenz-entlade- (d70, d80, d90, d100) oder -ladekurven für mehrere unterschiedliche Strom- und/oder Temperaturbedingungen enthält.

6. Verfahren nach einem der Ansprüche 1 bis 5, wobei die Bibliothek Referenz-Entlade- (d70, d80, d90, d100) oder -Ladekurven für mehrere verschiedene Alterungsbedingungen enthält, und wobei in Schritt d) die Referenzkurve unter Berücksichtigung der Alterungsbedingungen der Batterie ausgewählt wird.

7. Verfahren nach einem der Ansprüche 1 bis 6, wobei die Referenzbibliothek eine Vielzahl von Referenz-Entladungs- (d70, d80, d90, d100) oder - Ladungskurven für eine jeweilige Vielzahl von diskreten Werten des Gesundheitszustands aufweist.

8. Verfahren nach Anspruch 7, wobei die in Schritt d) ausgewählte Referenzkurve die in der Bibliothek verfügbare Referenzkurve für den größten Zustandswert ist, der streng unter dem in Schritt c) bestimmten Zustandsindikator der ersten Zelle (Ci_lim) liegt.

9. Verfahren nach einem der Ansprüche 1 bis 8, ferner aufweisend:
- vor der Entladephase (101) einen Schritt des Aufladens der Batterie bis zu einem Vollladeschwellenwert; oder
- vor der Ladephase einen Schritt des Entladens der Batterie bis zu einem Entladeschwellenwert.

10. Verfahren nach Anspruch 9, wobei der vorherige Schritt des Ladens oder Entladens der Batterie das Ausgleichen der Zellen (Ci) der Batterie aufweist.

11. Verfahren zum Aufwerten gebrauchter Batteriezellen, aufweisend einen Schritt der Diagnose der Zellen der eine Verfahren nach einem der Ansprüche 1 bis 10 implementiert.

12. Verfahren nach Anspruch 11 in Abhängigkeit von Anspruch 3, ferner aufweisend einen Schritt des Auswählens von Zellen (Ci), deren Gesundheitszustandsindikator eine vordefinierte Bedingung erfüllt, und einen Schritt des Zusammenfügens der ausgewählten Zellen zu einer neuen Batterie.

## Claims

1. Method for determining the state of health of the cells (Ci) of a battery including a plurality of cells (Ci) connected in series, this method including the following steps:
a) during a discharge (101) or charge phase of the battery, measuring the voltage (Ui) across the terminals of each cell (Ci);
b) when a first cell (Ci_lim) reaches a predefined end-of-discharge or end-of-charge condition, stopping (102) discharging or charging the battery, and storing, for each other cell (Ci), the voltage (Ui) of the cell at the end of the battery discharge or charge phase;
c) determining the charge Qtot extracted from the battery or injected in the battery between the start and the end of a full discharge or charge phase of the battery, and inferring (103) a state of health of the first cell (Ci_lim);
d) selecting (104), from a library of reference discharge or charge curves, as a function of the state of the health indicator of the first cell (Ci_lim) calculated in step c), a reference curve representative of the evolution of the voltage (U) of the first cell as a function of the charge extracted from the first cell or injected into the first cell; and
e) determining (105), for each other cell (Ci) of the battery, from the reference curve selected in step d), an estimate of the charge variation ΔQCi undergone by the cell between:
- the passage of the first cell (Ci_lim) to a voltage (Ui) equal to the voltage of the other cell (Ci) at the end of the battery discharge or charge phase, and
- the end of the battery discharge or charge phase.

2. Method according to claim 1, further including supplying, for each other cell (Ci) of the battery, an estimated value of the capacity of the cell equal to Qtot+ΔQCi.

3. Method according to claim 2, further including supplying, for each other cell (Ci) of the battery, a state of health indicator of the cell calculated by taking into account said estimated value of the capacity Qtot+ΔQCi of the cell.

4. Method according to any one of claims 1 to 3, wherein, in step a), the discharging or charging of the battery is performed under current and/or temperature conditions substantially identical to those for which the reference curves (d70, d80, d90, d100) were plotted from the library.

5. Method according to any of claims 1 to 4, wherein the library contains reference discharge (d70, d80, d90, d100) or charge curves for several distinct current and/or temperature conditions.

6. method according to any one of claims 1 to 5, wherein the library contains reference discharge (d70, d80, d90, d100) or charge curves for several distinct aging conditions, and wherein, in step d), the reference curve is selected taking into account the aging conditions of the battery.

7. Method according to any one of claims 1 to 6, wherein the reference library comprises a plurality of reference discharge (d70, d80, d90, d100) or charge curves for respectively a plurality of discrete values of state of health.

8. Method according to claim 7, wherein the reference curve selected in step d) is the reference curve available in the library for the greatest health state value strictly lower than the health state indicator of the first cell (Ci_lim) determined in step c).

9. Method according to any of claims 1 to 8, further comprising:
- prior to said discharge phase (101), a step of charging the battery up to a full charge threshold; or
- prior to said charge phase, a step of discharging the battery up to a discharge threshold.

10. Method according to claim 9, wherein the prior step of charging or discharging the battery comprises balancing the cells (Ci) of the battery.

11. Method for upgrading used battery cells including a step of diagnosing the cells implementing a method according to any one of claims 1 to 10.

12. Method according to claim 11 in its dependency on claim 3, further including a step of selecting cells (Ci) the state of health indicator of which satisfies a predefined condition, and a step of assembling the selected cells into a new battery.
